# FASCICULE DE BREVET EUROPEEN

(11) **EP 3 474 025 B1**
(45) Date de publication et mention de la délivrance du brevet: **15.03.2023**
(21) Numéro de dépôt: 18199712.3
(22) Date de dépôt: 10.10.2018
(51) Int. Cl.: G01R 15/18, G01R 15/20

(54) **CAPTEUR POUR LA MESURE D'UN COURANT DE SORTIE D'UN SYSTEME ELECTRIQUE**
MESSFÜHLER ZUM MESSEN DES AUSGANGSSTROMS EINES ELEKTRISCHEN SYSTEMS
SENSOR FOR MEASURING AN OUTPUT CURRENT OF AN ELECTRICAL SYSTEM

(30) Priorité: 17.10.2017 FR 1759718
(43) Date de publication de la demande: 24.04.2019
(73) Titulaire: Valeo eAutomotive France SAS, 95800 Cergy (FR)
(72) Inventeur: LAMARCHE, Anthony, 78450 VILLEPREUX (FR); GILET, Olivier, 95270 VIARMES (FR)
(74) Mandataire: Argyma

(56) Documents cités:
- DE-A1-102017 107 069
- US-A1- 2015 245 534
- US-A1- 2015 260 762

## Description

### DOMAINE TECHNIQUE ET OBJET DE L'INVENTION

La présente invention se rapporte au domaine des capteurs de courant électrique, notamment des capteurs mesurant un courant à l'interface d'un premier système électrique et d'un deuxième système électrique connectés ensemble. L'invention concerne plus particulièrement la mesure du courant de sortie d'un onduleur connecté à une machine électrique, en particulier une machine électrique polyphasée de véhicule automobile.

L'invention vise notamment à permettre de mesurer l'intensité d'un courant de sortie d'un onduleur alimentant une machine électrique, ledit courant étant mesuré au niveau d'un connecteur électrique dudit onduleur, au moyen d'un capteur peu encombrant.

### ETAT DE LA TECHNIQUE

Comme cela est connu, un véhicule automobile électrique ou hybride comprend un système de motorisation électrique alimenté par une batterie d'alimentation haute tension via un réseau électrique embarqué haute tension et une pluralité d'équipements électriques auxiliaires alimentés par une batterie d'alimentation basse tension via un réseau électrique embarqué basse tension.

Une batterie d'alimentation haute tension assure une fonction d'alimentation en énergie du système de motorisation électrique permettant la propulsion du véhicule. Plus précisément, afin de commander le moteur électrique entrainant les roues du véhicule, il est connu d'utiliser un onduleur permettant de convertir le courant continu fourni par la batterie d'alimentation haute tension en un ou plusieurs courants de commande alternatifs, par exemple sinusoïdaux.

De façon plus générale, dans la suite du présent document, il est fait référence à une machine électrique connectée électriquement à un système électrique. En particulier, il peut s'agir d'une machine électrique tournante alimentée en énergie électrique par l'intermédiaire d'un onduleur.

Un onduleur est classiquement configuré pour réaliser la conversion du courant continu, reçu de la batterie haute tension, en trois courants de phase alternatifs de commande du moteur. A cette fin, l'onduleur comprend des composants électriques par lesquels passe l'énergie alimentant la machine électrique, ainsi qu'une unité électronique de contrôle comprenant des composants électroniques permettant de contrôler les composants électriques de l'onduleur. Les composants électriques de l'onduleur peuvent être agencés dans un module électronique de puissance. Typiquement, le module électronique de puissance comprend un corps comportant les composants électriques par lesquels passe l'énergie alimentant la machine électrique.

Ainsi, il est précisé que, par « module électronique de puissance », on entend un ensemble comprenant des composants par lesquels passe de l'énergie alimentant la machine électrique, notamment destinés à transformer le courant continu en courants alternatifs ou vice-versa. Ces composants peuvent comprendre des interrupteurs électroniques, tels que par exemple des transistors semi-conducteurs, agencés en circuit électrique pour permettre un passage commandé d'énergie électrique entre la batterie d'alimentation haute tension et la machine électrique. En particulier, les composants sont des puces semi-conductrices nues pour lesquels le corps réalise une encapsulation. Autrement dit, un module électronique de puissance est un ensemble comprenant une pluralité de puces semi-conductrices formant un circuit électrique encapsulées dans un même boîtier.

L'onduleur comporte aussi des connecteurs électriques de sortie, au nombre de trois en triphasé, connectés aux phases de la machine électrique. La connexion entre les connecteurs électriques de l'onduleur et les connecteurs de phase de la machine électrique est réalisée par un contact plan, selon un plan de réception respectif pour chaque connexion entre un connecteur électrique de sortie de l'onduleur et un connecteur de phase de la machine électrique.

Dans le cas où la moteur électrique est un moteur triphasé, le moteur comprend trois connecteurs électriques, dits « connecteurs de phase », et l'onduleur comprend trois connecteurs électriques reliés aux connecteurs de phase du moteur afin de commander ledit moteur en utilisant trois courants dits « de phase » déphasés deux à deux, par exemple de 120°. Ces courants de phase sont générés par l'onduleur à partir du courant délivré par la batterie haute tension.

Comme cela est connu, afin de contrôler le fonctionnement d'un système électrique contrôlant une machine électrique, tel qu'un onduleur contrôlant un moteur électrique, la connaissance du courant circulant dans chaque phase de la machine électrique est nécessaire afin de réaliser une commande adaptée de l'onduleur alimentant ladite machine électrique en énergie électrique.

Dans ce but, il est connu de réaliser une mesure de champ magnétique au niveau de chaque connecteur de sortie du système électrique considéré. Chaque connecteur électrique de sortie du système électrique considéré, également désigné « leadframe » selon le terme en langue anglaise connu de l'homme de l'art, est relié à un connecteur de phase de la machine électrique.

Un capteur mesurant le champ magnétique est par conséquent disposé de manière à mesurer le champ magnétique induit par le courant au niveau de chaque connecteur de sortie du système électrique. La valeur de chaque champ magnétique est remontée à une carte électronique pour déterminer l'intensité de chaque courant de sortie.

Par exemple, le document US 2015/245534 A1 concerne des barres de connexions électriques interconnectées comprenant des C magnétiques pour centrer des flux magnétiques et ainsi mesurer des courants dans les barres de connexions électriques.

Dans le contexte décrit ci-dessus, les capteurs de champ magnétique utilisés dans l'état de la technique s'étendent dans le prolongement de chaque connecteur électrique du système électrique, en particulier les connecteurs de sortie d'un onduleur. Chaque connecteur électrique du système électrique est respectivement aligné avec un connecteur de phase situé en vis-à-vis. Ainsi, certains capteurs de champ magnétique connus comprennent, pour chaque connecteur de sortie du système électrique, un moyen de mesure du champ magnétique en forme de C, ci-après désigné « C magnétique », avec un entrefer, et une carte électronique. La mesure de champ magnétique est ainsi réalisée au niveau de l'entrefer desdits C magnétiques puis est par exemple acheminée jusqu'à la carte électronique.

Plus précisément, chaque courant de sortie passe dans une ouverture principale du C magnétique correspondant, ce dernier captant alors le champ magnétique induit qui est mesuré et transmis à la carte électronique, ladite carte électronique déterminant l'intensité de chaque courant de phase. On désigne par ouverture principale, l'ouverture délimitée par la forme en C du C magnétique. Autrement dit, le C magnétique s'étend dans un plan principal dans lequel il a la forme en C. Ladite ouverture principale est délimitée dans le plan principal par ladite forme en C. L'ouverture principale correspond donc à l'espace intérieur délimité par le C magnétique.

La largeur des C magnétiques est de préférence configurée pour optimiser la compacité du capteur, dans la mesure du possible, de manière à mesurer un champ magnétique adapté pour permettre la détermination de chaque courant de sortie, sans toutefois saturer ledit capteur.

Selon l'état de l'art, chaque connecteur de phase du moteur électrique est vissé sur un connecteur électrique de sortie de l'onduleur, à l'extrémité du connecteur électrique issu de l'onduleur. Le vissage des connecteurs de phase sur les connecteurs de sortie nécessite de prévoir une zone à l'extrémité du connecteur de sortie pour l'installation de la vis.

Or, aujourd'hui, en particulier dans le domaine de l'automobile, les contraintes liées à l'encombrement sont de plus en plus fortes. Ainsi, toujours dans le contexte d'un moteur électrique alimenté via un onduleur, l'onduleur est aujourd'hui placé le plus près possible du moteur électrique, et la présence de zones de vissage aux extrémités des conducteurs de sortie de l'onduleur est préjudiciable, dans l'état de l'art, car le volume occupé, in fine, est important, dans la mesure où le moteur électrique se trouve éloigné de l'onduleur à cause des dites zones de vissage.

Il existe donc un besoin pour un capteur de champ magnétique permettant la détermination d'un courant de sortie d'un onduleur qui permette une diminution de l'encombrement engendré.

Pour répondre à ce besoin, la présente invention propose un capteur comprenant un conducteur électrique qui est apte à recevoir, dans des portions distinctes respectives, un connecteur électrique de sortie d'un premier système électrique, tel qu'un onduleur, et un connecteur d'un deuxième système électrique, tel qu'une machine électrique.

Le conducteur électrique du capteur selon l'invention comporte une première portion apte à recevoir un connecteur électrique du premier système électrique et une deuxième portion apte à recevoir un connecteur électrique du deuxième système électrique. Le capteur selon l'invention comprend par ailleurs un C magnétique disposé de façon à capter le champ magnétique induit par le courant de sortie du premier système électrique. L'ouverture principale dudit C magnétique se trouve à proximité de la première portion du conducteur électrique et est déportée par rapport à la deuxième portion.

### PRESENTATION GENERALE DE L'INVENTION

Plus précisément, l'invention a tout d'abord pour objet un capteur destiné à la mesure d'un courant de sortie d'un premier système électrique connecté à un deuxième système électrique, ledit capteur comprenant au moins un C magnétique s'étendant dans un plan principal dans lequel il a une forme en C, ledit C magnétique présentant une ouverture principale délimitée dans le plan principal par ladite forme en C, ledit capteur comprenant au moins un conducteur électrique comportant au moins une première portion configurée pour recevoir un connecteur électrique du premier système électrique et au moins une deuxième portion configurée pour recevoir un connecteur électrique du deuxième système électrique de manière à assurer une liaison électrique entre le premier et le deuxième système électrique, ladite première portion se trouvant en vis-à-vis de l'ouverture principale du C magnétique et la deuxième portion étant déportée par rapport au C magnétique suivant le plan principal. En particulier, le premier système électrique est un onduleur et le deuxième système électrique est une machine électrique alimentée par l'onduleur.

Grâce à la présente invention, les courants circulant dans des connecteurs de sortie du premier système électrique, notamment un onduleur, peuvent être mesurés au moyen de C magnétiques intégrés à un capteur engendrant un encombrement réduit. En effet, des contraintes de place liées à la fixation du deuxième système, notamment un moteur électrique alimenté par l'onduleur, ne sont plus mis en oeuvre sur le conducteur de sortie du premier système, mais à côté, ce qui permet de rapprocher le premier système électrique du deuxième système électrique.

Selon un mode de réalisation, le plan principal dudit au moins un C magnétique est orthogonal à un plan selon lequel s'étend ladite au moins une deuxième portion du conducteur électrique.

Selon un autre mode de réalisation, le plan principal dudit au moins un C magnétique s'étend dans un plan parallèle au plan de ladite au moins une deuxième portion.

Selon un mode de réalisation, le conducteur électrique comprend une troisième portion reliant la première portion et la deuxième portion, la troisième portion s'étendant de sorte que la deuxième portion se trouve à distance de la première portion et du C magnétique suivant une direction parallèle au dit plan principal du C magnétique. Ainsi, la zone de fixation du deuxième système électrique se trouve à côté du connecteur électrique du premier système, et non plus sur le connecteur électrique du premier système électrique comme c'est le cas dans l'art antérieur. Des contraintes liées à la fixation du connecteur du deuxième système électrique, telles qu'une surface minimale pour la fixation du deuxième système, ne sont donc plus imposées sur le connecteur électrique du premier système, ce qui permet de réduire l'encombrement du premier et du deuxième système.

Selon une variante, ladite deuxième portion et ladite troisième portion s'étendent dans des directions formant un angle compris entre 45° et 135° environ, de préférence sensiblement égal à 90°. En particulier, la deuxième portion s'étend suivant une direction lui permettant de prévoir une zone de fixation du connecteur électrique du deuxième système électrique. La troisième portion forme une extension de la deuxième portion du conducteur électrique, la troisième portion s'étendant dans une direction, notamment orthogonale, pour rejoindre la première portion destinée à recevoir un connecteur électrique du premier système électrique.

Selon une variante, le conducteur électrique comporte une lame comprenant un décrochement s'étendant depuis une première partie extrémale de la lame jusqu'à une deuxième partie extrémale de la lame qui est opposée à la première partie extrémale, ladite deuxième portion du conducteur électrique étant comprise dans la première partie extrémale, ledit décrochement définissant ladite troisième portion du conducteur électrique, et le C magnétique étant au moins en parti logé dans ledit décrochement. Ainsi, la troisième portion du conducteur électrique forme une sorte d'extension de la deuxième portion, cette troisième portion permettant de rejoindre la première portion destinée à recevoir un connecteur du premier système électrique. Cet agencement du conducteur électrique du capteur et du C magnétique permet de réduire encore l'encombrement du premier système connecté au deuxième système électrique. En effet, la troisième portion du conducteur électrique permet de déporter la deuxième portion, c'est-à-dire la zone de fixation du connecteur du deuxième système électrique, à côté de la tranche du C magnétique. Par exemple, le gain de place entre un onduleur et le moteur électrique alimenté par l'onduleur peut être de l'ordre de 15 mm sur la distance séparant l'onduleur et le moteur électrique, par rapport aux solutions connues. En particulier, la première portion du conducteur électrique est dans le prolongement de la troisième portion du conducteur électrique. La lame sans le décrochement a notamment une forme parallélépipédique.

Selon une variante, la troisième portion est parallèle au plan principal du C magnétique. Ainsi, l'encombrement du capteur suivant une direction orthogonale au plan principal du C magnétique est limité.

Selon un mode de réalisation, le ou les C magnétiques et le ou les conducteurs électriques sont maintenus ensemble par un corps. Ainsi, le capteur forme un ensemble d'un seul tenant. Le corps du capteur est par exemple surmoulé sur les C magnétiques et le ou les conducteurs électriques.

Selon un mode de réalisation, le capteur comprend trois premières portions destinées à recevoir des connecteurs électriques respectifs du premier système électrique et trois deuxièmes portions destinées à recevoir des connecteurs électriques respectifs du deuxième système électrique, ledit capteur comprenant trois C magnétiques pour permettre la mesure du champ magnétique induit par un courant respectif circulant entre un connecteur du premier système électrique et un connecteur du deuxième système électrique respectifs. Ce capteur est particulièrement adapté lorsque le premier système électrique est un onduleur et le deuxième système électrique est un moteur électrique triphasé alimenté par l'onduleur.

Selon une variante, les C magnétiques sont alignés de sorte que leurs plans principaux sont parallèles, en particulier confondus. Cet agencement permet de réduire encore l'encombrement du capteur.

Selon un mode de réalisation, le capteur comprend au moins un élément sensible au champ magnétique dans l'entrefer dudit au moins un C magnétique ainsi qu'un circuit de détermination d'un courant en fonction de la valeur du champ magnétique mesuré. En particulier, l'entrefer désigne l'espace compris entre les extrémités du C magnétique.

La présente invention vise également un ensemble comprenant une carte électronique de contrôle et un capteur selon l'invention, ladite carte électronique de contrôle comprenant ledit élément sensible au champ magnétique dans l'entrefer dudit au moins un C magnétique et ledit circuit de détermination d'un courant en fonction de la valeur du champ magnétique mesuré. En particulier, la carte électronique de contrôle est également une unité de contrôle du premier système, notamment configurée pour commander des interrupteurs de puissance du premier système. La présente invention vise par ailleurs un ensemble comprenant un capteur selon l'invention et un premier système électrique, notamment un onduleur, dans lequel un connecteur du premier système électrique traverse le C magnétique à travers ladite ouverture principale pour venir en contact avec la première portion du conducteur électrique, de sorte que le C magnétique est configuré pour générer un champ magnétique fonction du courant circulant dans ledit connecteur du premier système électrique. Ledit ensemble peut comprendre une carte électronique telle que décrite précédemment.

Avantageusement, ledit premier système comporte un module électronique de puissance, ledit module électronique de puissance étant contrôlé par ladite carte électronique de contrôle. Notamment le connecteur de sortie du premier système est issu dudit module électronique de puissance.

Selon un mode de réalisation, l'ensemble comprend en outre un deuxième système électrique, notamment un moteur électrique, dans lequel un connecteur du deuxième système électrique, notamment un connecteur de phase du moteur électrique, est connecté à la deuxième partie du conducteur électrique du capteur. Notamment, la dimension de la première portion du conducteur électrique suivant une direction perpendiculaire au plan principal du C magnétique est inférieure à la dimension de la deuxième portion du conducteur électrique suivant la direction perpendiculaire au plan principal du C magnétique.

### PRESENTATION DES FIGURES

L'invention sera mieux comprise à la lecture de la description qui va suivre, donnée uniquement à titre d'exemple, et se référant aux dessins annexés donnés à titre d'exemples non limitatifs, dans lesquels des références identiques sont données à des objets semblables et sur lesquels :
- la figure 1 est une vue en coupe d'un exemple de capteur de champ magnétique selon l'invention,
- la figure 2 est une vue de coté du capteur illustré en figure 1,
- la figure 3 est une vue en perspective du capteur illustré en figure 1,
- La figure 4 est une vue de dessus d'un conducteur électrique du capteur illustré en figure 1,
- La figure 5 est une vue schématique d'un ensemble comprenant le capteur de la figure 1.

Il faut noter que les figures exposent l'invention de manière détaillée pour mettre en oeuvre l'invention, lesdites figures pouvant bien entendu servir à mieux définir l'invention le cas échéant.

### DESCRIPTION DETAILLEE DE L'INVENTION

Dans la description qui sera faite ci-après, l'invention sera décrite dans son application à un véhicule automobile électrique ou hybride sans que cela ne soit limitatif de la portée de la présente invention.

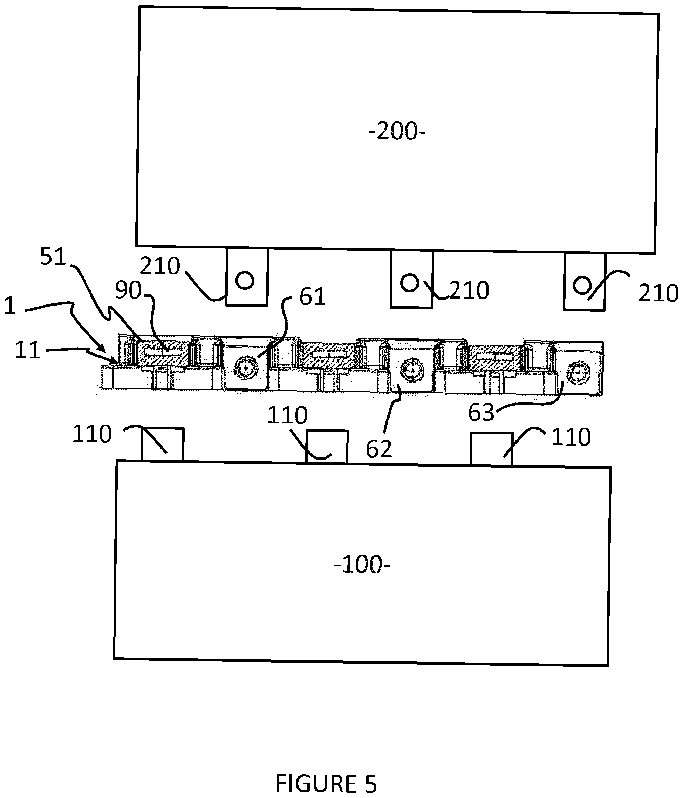

Dans l'exemple illustré en figure 5 décrit ci-après, un tel véhicule comprend une machine électrique 200, un onduleur 100, et notamment une batterie d'alimentation haute tension, un réseau électrique embarqué haute tension, une batterie d'alimentation basse tension, un réseau électrique embarqué basse tension et une pluralité d'équipements électriques auxiliaires. En particulier, la machine électrique 200 est un moteur électrique triphasé.

Toutefois, le contexte envisagé ne limite pas a priori la portée de la présente invention et le capteur revendiqué pourrait être mis en oeuvre dans d'autres contextes, par exemple entre un chargeur électrique embarqué dans un véhicule et un système électrique permettant une connexion avec une borne de recharge. En pratique, ledit capteur s'adapte sur un connecteur électrique d'un premier système électrique connecté à un deuxième système électrique, dans le but de déterminer le courant circulant dans un connecteur électrique dudit premier système électrique.

Pour revenir à l'application envisagée dans un véhicule automobile, la machine électrique 200 est en pratique une machine électrique tournante, de préférence destinée à entraîner les roues du véhicule à partir de l'énergie fournie par la batterie d'alimentation haute-tension. Plus précisément, la machine électrique 200 est une machine électrique à courant alternatif alimentée par une source de courants polyphasés. Par exemple, la machine électrique 200 peut être un moteur à courant alternatif. Dans l'exemple préféré décrit ci-après, la machine électrique 200 est alimentée par une source de courants triphasés sans que cela ne soit limitatif de la portée de la présente invention.

Dans cet exemple, la commande de la machine électrique 200 est réalisée au moyen de l'onduleur 100. Ledit onduleur 100 permet de convertir le courant continu fourni par la batterie d'alimentation haute tension en trois courants de commande alternatifs, par exemple sinusoïdaux. Autrement dit, l'onduleur 100 a pour fonction de transformer le courant continu délivré en entrée par la batterie d'alimentation haute tension en trois courants de phase permettant de commander la machine électrique 200. A l'inverse, dans un autre mode de fonctionnement, la machine électrique 200 peut également fournir trois courants alternatifs à l'onduleur 100 afin que ledit onduleur 100 les transforme en un courant continu permettant de charger la batterie d'alimentation haute-tension.

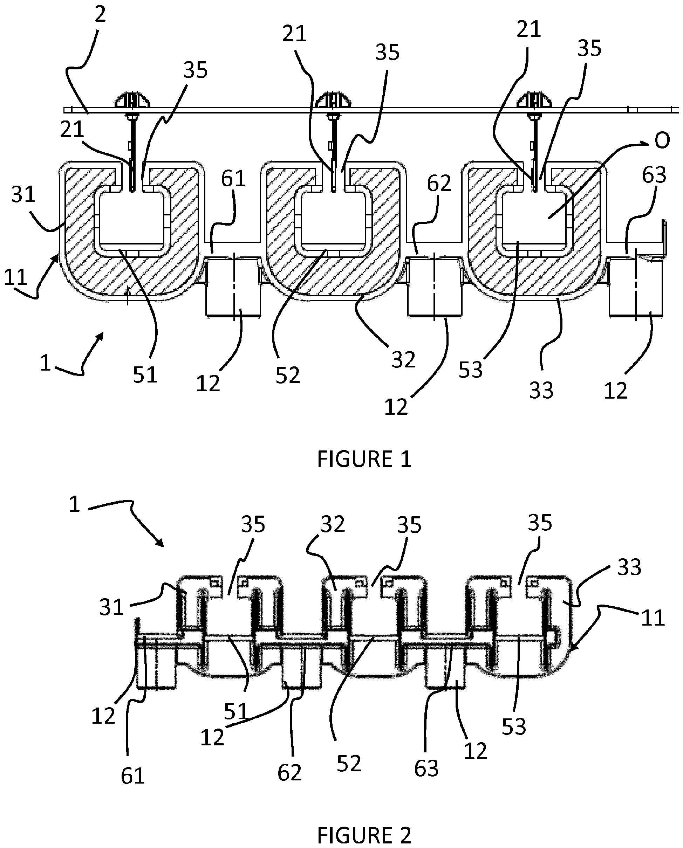

Les figures 1 à 3 montrent trois angles de vue différents d'un capteur 1 selon un mode de réalisation de l'invention, comprenant en l'espèce trois C magnétiques 31, 32, 33 pour mesurer le champ magnétique induit par le courant circulant dans trois connecteurs électriques de sortie 110 d'un onduleur 100.

Le capteur 1 comporte au moins un conducteur électrique 41,42, 43. Le conducteur électrique 41, 42, 43 comporte une première portion 51, 52, 53 et au moins une deuxième portion 61, 62, 63 correspondante. La première portion 51, 52, 53 est prévue pour recevoir un connecteur électrique 110 du premier système électrique 100, en particulier de l'onduleur 100 dans l'application décrite ici. La deuxième portion 61, 62, 63 est prévue pour recevoir un connecteur électrique 210 du deuxième système électrique 200, en particulier de la machine électrique 200 dans l'application décrite ici. Dans le cas d'une machine électrique 200 triphasée alimentée via un onduleur 100, il est bien entendu que le capteur 1 comprend trois conducteurs 41, 42, 43 et donc trois premières portions 51, 52, 53 pour recevoir trois connecteurs électriques 110 de l'onduleur 100 et trois deuxièmes portions 61, 62, 63 pour recevoir trois connecteurs électriques 210 de la machine électrique 200.

En outre, les C magnétiques 31, 32, 33 présentent chacun une ouverture principale O délimitée par la forme en C du C magnétique 31, 32, 33. Autrement dit, le C magnétique 31, 32, 33 s'étend dans un plan principal dans lequel il a la forme en C. Ladite ouverture principale O est délimitée dans le plan principal par ladite forme en C. L'ouverture principale O correspond donc à l'espace intérieur délimité par le C magnétique 31, 32, 33. Les C magnétiques 31, 32, 33 sont notamment alignés de sorte que leurs plans principaux sont confondus, ce qui permet de réduire l'encombrement du capteur 1 entre l'onduleur 100 et la machine électrique 200.

La machine électrique 200 peut présenter des contraintes liées à la fixation de ses connecteurs électriques 210. Par exemple, les fixations des connecteurs électriques 210 doivent supporter les vibrations de la machine 200 lors de son fonctionnement ou permettre de compenser les incertitudes d'alignement des connecteurs électriques 210. Ainsi, une fixation par vissage sera notamment plus adaptée pour les connecteurs électriques 210 de la machine électrique 200 car le couple de serrage permet un maintien sûr des fixations. D'autres fixations pourraient être envisagées par exemple par clipsage ou toute autre fixation mettant en jeu un engrenage mécanique avec la partie sur laquelle est connecté le connecteur 210 de la machine électrique 200. Or, ces contraintes de fixation se traduisent par une surface nécessaire à la mise en oeuvre de la fixation. Inversement, l'onduleur 100 peut présenter des contraintes liées à la fixation de ses connecteurs électriques 110, qui sont moindres que celles liées à la fixation des connecteurs 210 de la machine électrique 200. Par exemple, l'onduleur 100 subit moins de vibrations que la machine électrique 200. Ainsi, une fixation par soudage pourra être adaptée pour les connecteurs électriques 110 de l'onduleur 100. Typiquement, une telle fixation par soudage requiert moins de place que la connexion envisagée pour les connecteurs 210 de la machine électrique 200, au moins suivant une direction séparant l'onduleur 100 et la machine électrique 200.

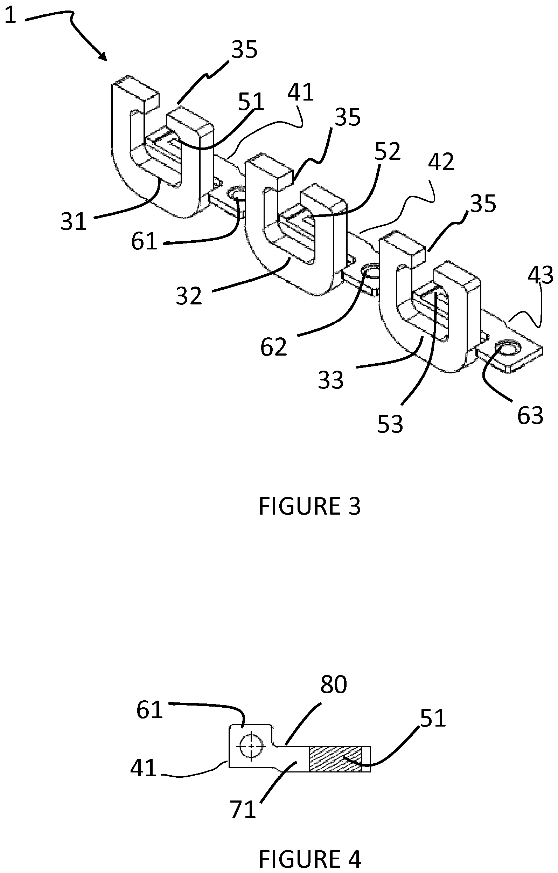

Comme par exemple visible en figures 3 ou 5, la première portion 51, 52, 53 se trouve en vis-à-vis de l'ouverture principale O du C magnétique 31, 32, 33, ce qui lui permet de recevoir le connecteur électrique 110 de l'onduleur 100 qui passe à travers le C magnétique 31, 32, 33. La deuxième portion 61, 62, 63 recevra les connecteurs électriques 210 de la machine électrique 200. Cette deuxième portion 61, 62, 63 est déportée par rapport au C magnétique 31, 32, 33 suivant le plan principal du C magnétique 31, 32, 33. Ainsi, les connecteurs électriques 210 de la machine électrique 200 ne sont plus fixés sur les connecteurs 110 comme dans l'art antérieur, mais sur une plage de connexion située à côté du connecteur 110 de l'onduleur 100. Cela permet de diminuer la distance entre l'onduleur 100 et la machine électrique 200 et donc de réduire l'encombrement de l'ensemble comprenant l'onduleur 100 et la machine électrique 200.

La figure 4 illustre un exemple de conducteur 41, compris dans le capteur 1 illustré en figure 1. Les autres conducteurs électriques 42, 43 du capteur 1 sont en particulier identiques à celui 41 illustré en figure 4. En figure 4, la première portion 51 est représentée par des hachures. Le conducteur électrique 41 comprend notamment une troisième portion 71 reliant la première portion 51 et la deuxième portion 61. Grâce à la troisième portion 71, la deuxième portion 61 se trouve à distance de la première portion 51 et du C magnétique 31 suivant une direction parallèle au plan principal du C magnétique 31.

En particulier, la deuxième portion 61 et la troisième portion 71 s'étendent dans des directions formant un angle égal à 90°. La deuxième portion 61 s'étend suivant une direction lui permettant de prévoir une surface suffisante pour la zone de fixation du connecteur électrique 210 de la machine électrique 200. La troisième portion 71 s'étend dans une direction orthogonale à celle de la première portion 61, pour rejoindre la première portion 51 sur laquelle le connecteur électrique 110 de l'onduleur 100 va être fixé. Les directions pourraient avoir un angle différent en fonction notamment de la direction du connecteur 210 de la machine électrique 200. Un angle de 90° permet d'avoir un encombrement réduit du capteur 1.

Notamment, le conducteur électrique 41 est une lame comprenant un décrochement 80 qui s'étend depuis une première partie extrémale de la lame jusqu'à une deuxième partie extrémale de la lame qui est opposée à la première partie extrémale, la première partie extrémale comprenant la deuxième portion 61 du conducteur électrique 41. Le décrochement 80 définit la troisième portion 71. La troisième portion 71 forme donc une extension de la deuxième portion 61. Comme illustré en figure 3, le C magnétique 31 vient se loger au moins en parti dans le décrochement 80. La zone de fixation du connecteur 210 de la machine électrique 200 est donc à côté de la tranche du C magnétique 31. Autrement dit, depuis la première portion 51, la troisième portion 71 s'étend face au plan principal du C magnétique 31 jusqu'à dépasser un coté du C magnétique 31 permettant ainsi à la deuxième portion 61 de s'étendre sur le côté du C magnétique 31. Cet agencement permet de réduire encore l'encombrement du capteur 1, suivant notamment une direction perpendiculaire au plan principal du C magnétique 31. Ainsi, le gain de place entre un onduleur 100 et la machine électrique 200 alimentée par l'onduleur 100 peut être de l'ordre de 15 mm sur la distance séparant l'onduleur 100 et la machine électrique 200, par rapport aux solutions connues. En particulier, la première portion 51 est comprise dans la deuxième partie extrémale de la lame. Notamment, la première portion 51 est formée dans le prolongement de la troisième portion 71. La lame sans le décrochement 80 a notamment une forme parallélépipédique, voir rectangulaire. D'autres décrochements peuvent aménagés dans la lame pour améliorer son intégration dans le capteur 1.

Dans le capteur 1, entre deux C magnétiques consécutifs 31, 32, la deuxième portion 61 du premier C magnétique 31 peut se loger, au moins en partie, dans l'espace situé entre son C magnétique respectif 31 et le C magnétique suivant 32, toujours en vu de réduire l'encombrement du capteur 1 entre l'onduleur 100 et la machine électrique 200.

Le plan principal de chaque C magnétique 31, 32, 33 peut être orthogonal à la première portion 51, 52, 53 de son conducteur électrique 41, 42, 43 respectif. En outre, le plan principal de chaque C magnétique 31, 32, 33 peut être orthogonal au plan des deuxièmes portions 61, 62, 63 de son conducteur électrique 41, 42, 43 respectif, comme par exemple illustré sur les figures 1 à 5. Alternativement, le plan principal de chaque C magnétique 31, 32, 33 peut être parallèle au plan des deuxièmes portions 61, 62, 63, ces deuxièmes portions 61, 62, 63 s'étendant par exemple du côté opposé par rapport à une carte électronique de contrôle 2 décrite dans ce qui suit.

Selon un mode de réalisation, les C magnétiques 31, 32, 33, les conducteurs 41, 42, 43 forment de préférence une pièce d'un seul tenant, autrement dit monobloc, par exemple tel que dans le capteur 1 représenté sur les figures 1 à 5. Notamment, les C magnétiques 31, 32, 33 et les conducteurs 41, 42, 43 sont maintenus ensemble par le corps 11 du capteur 1. Le corps 11 est notamment en matière isolante électriquement, par exemple un plastique. Le corps 11 est par exemple surmoulé sur les C magnétiques 31, 32, 33, et les conducteurs 41, 42, 43. Par ailleurs, le corps 11 peut être apte à guider les connecteurs 210 de la machine électrique 200 et/ou les connecteurs de sortie 110 de l'onduleur 100. A cette fin, le corps 11 peut comprendre des nervures pour aider au guidage desdits connecteurs 110, 210. Le corps 11 n'est pas représenté en figure 3.

Sur la figure 1, le capteur 1 comprend des éléments 21 sensibles au champ magnétique susceptible d'être présent dans l'entrefer 35 de chaque C magnétique 31, 32, 33 afin de permettre la détermination du courant circulant dans les connecteurs électriques 110 de l'onduleur 100 disposés à proximité desdits C magnétiques 31, 32, 33. L'entrefer 35 d'un C magnétique 31, 32, 33 est notamment formé entre les extrémités du C magnétique 31, 32, 33.

Ledit capteur 1 peut être en relation avec une carte électronique de contrôle 2, par exemple comme représenté sur la figure 1. Toujours en référence à la figure 1, selon un mode de réalisation, les éléments 21 sensibles au champ magnétique dans l'entrefer 35 de chaque C magnétique 31, 32, 33, sont montés sur la carte électronique de contrôle 2. La carte électronique 2 appartient notamment à une unité électronique de contrôle de l'onduleur 100. Dès lors, ladite carte électronique de contrôle 2 comprend des composants électroniques adaptés pour déterminer chaque courant circulant dans les connecteurs 110 de l'onduleur 100 à partir du champ magnétique mesuré au moyen des éléments sensibles 21 et des C magnétiques 31, 32, 33.

Chaque connecteur de sortie 110 de l'onduleur 100 passe à travers l'ouverture principale O d'un C magnétique 31, 32, 33 respectif. Les C magnétiques 31, 32, 33 génèrent chacun un champ magnétique fonction du courant circulant dans le connecteur de sortie 110 de l'onduleur 100. Le champ magnétique induit dans chaque C magnétique 31, 32, 33 est détecté au moyen de l'élément sensible 21 qui transforme le champ magnétique en un courant délivré à la carte électronique de contrôle 2. Par exemple, l'élément sensible 21 est un capteur à effet hall.

En particulier, la figure 5 représente l'onduleur 100, la machine électrique 200 et le capteur 1 dans un état non assemblé. Les connecteurs de sortie 110 de l'onduleur 100 passent à travers l'ouverture principale O des C magnétiques 31, 32, 33 et sont positionnés en contact avec les premières portions 51, 52, 53 des conducteurs 41, 42, 43 du capteur 1, puis fixés, notamment par soudage, au niveau des premières portions 51, 52, 53. En particulier, des paillons d'argent 90 peuvent être déposés au préalable sur les premières portions 51, 52, 53 pour l'opération de soudage. Les connecteurs de phase 210 du moteur 200 sont positionnés en contact avec les deuxièmes portions 61, 62, 63 des conducteurs 41, 42, 43 du capteur 1, et fixés, notamment par vissage, au niveau des deuxièmes portions 61, 62, 63. Des futs taraudés 12 visibles en figures 1 et 2, sont notamment aménagés dans le capteur 1, en particulier dans le corps 11 du capteur 1 pour recevoir les vis. Les conducteurs de sortie 110 de l'onduleur 100 peuvent être des conducteurs de sortie d'un module électronique de puissance compris dans l'onduleur 1.

Comme expliqué précédemment, la dimension de la première portion 51, 52, 53 du conducteur électrique 41, 42, 43 entre l'onduleur 100 et la machine électrique 200 est inférieure à la dimension de la deuxième portion 61, 62, 63 du conducteur électrique 41, 42, 43 entre l'onduleur 100 et la machine électrique 200, ce qui permet de réduire la distance entre l'onduleur 100 et la machine électrique 200 par rapport à l'art antérieur.

L'invention ne se limite pas au seul exemple décrit ci-dessus. Les figures représentent un exemple particulier de réalisation qui combine plusieurs modes de réalisation. Cependant, les caractéristiques liées aux modes de réalisation peuvent-être indépendantes entre elles d'un mode à l'autre ou combinées entre elles.

## Revendications

1. Capteur (1) destiné à la mesure d'un courant de sortie d'un premier système électrique (100) connecté à un deuxième système électrique (200), ledit capteur (1) comprenant au moins un C magnétique (31, 32, 33) s'étendant dans un plan principal dans lequel il a une forme en C, ledit C magnétique (31, 32, 33) présentant une ouverture principale (O) délimitée dans le plan principal par ladite forme en C, ledit capteur (1) comprenant au moins un conducteur électrique (41, 42, 43) comportant au moins une première portion (51, 52, 53) configurée pour recevoir un connecteur électrique (110) du premier système électrique (100) et au moins une deuxième portion (61, 62, 63) configurée pour recevoir un connecteur électrique (210) du deuxième système électrique (200) de manière à assurer une liaison électrique entre le premier et le deuxième système électrique (100, 200), ladite première portion (51, 52, 53) se trouvant en vis-à-vis de l'ouverture principale (O) du C magnétique (31, 32, 33) **caractérisé en ce que** la deuxième portion (61, 62, 63) étant déportée par rapport au C magnétique (31, 32, 33) suivant le plan principal.

2. Capteur (1) selon la revendication 1, dans lequel le plan principal dudit au moins un C magnétique (31, 32, 33) est orthogonal à un plan selon lequel s'étend ladite au moins une deuxième portion (61, 62, 63) du conducteur électrique (41, 42, 43).

3. Capteur (1) selon l'une des revendications précédentes, dans lequel le conducteur électrique (41, 42, 43) comprend une troisième portion (71, 72, 73) reliant la première portion (51, 52, 53) et la deuxième portion (61, 62, 63), la troisième portion (71, 72, 73) s'étendant de sorte que la deuxième portion (61, 62, 63) se trouve à distance de la première portion (51, 52, 53) et du C magnétique (31, 32, 33) suivant une direction parallèle au dit plan principal du C magnétique (31, 32, 33).

4. Capteur (1) selon la revendication précédente, dans lequel ladite deuxième portion (61, 62, 63) et ladite troisième portion (71, 72, 73) s'étendent dans des directions formant un angle compris entre 45° et 135° environ, de préférence sensiblement égal à 90°.

5. Capteur (1) selon la revendication 3 ou 4, dans lequel le conducteur électrique (41, 42, 43) comporte une lame comprenant un décrochement (80) s'étendant depuis une première partie extrémale de la lame jusqu'à une deuxième partie extrémale de la lame qui est opposée à la première partie extrémale, ladite deuxième portion (61, 62, 63) du conducteur électrique (41, 42, 43) étant comprise dans la première partie extrémale, ledit décrochement (80) définissant ladite troisième portion (71, 72, 73) du conducteur électrique (41, 42, 43), et le C magnétique (31, 32, 33) étant au moins en parti logé dans ledit décrochement (80).

6. Capteur (1) selon l'une des revendications précédentes, comprenant trois premières portions (51, 52, 53) destinées à recevoir des connecteurs électriques (110) respectifs du premier système électrique (100) et trois deuxièmes portions (51, 52, 53) destinées à recevoir des connecteurs électriques (210) respectifs du deuxième système électrique (200), ledit capteur (1) comprenant trois C magnétiques (31, 32, 33) pour permettre la mesure du champ magnétique induit par un courant respectif circulant entre un connecteur (110) du premier système électrique (100) et un connecteur (210) du deuxième système électrique (200) respectifs.

7. Capteur (1) selon l'une des revendications précédentes, comprenant au moins un élément sensible (21) au champ magnétique dans l'entrefer (35) dudit au moins un C magnétique (31, 32, 33), ainsi qu'un circuit de détermination d'un courant en fonction de la valeur du champ magnétique mesuré.

8. Ensemble comprenant une carte électronique de contrôle (2) et un capteur (1) selon la revendication précédente, ladite carte électronique de contrôle (2) comprenant ledit élément sensible (21) au champ magnétique dans l'entrefer (35) dudit au moins un C magnétique (31, 32, 33) et ledit circuit de détermination d'un courant en fonction de la valeur du champ magnétique mesuré.

9. Ensemble comprenant un capteur (1) selon l'une des revendications 1 à 7 et un premier système électrique (100), notamment un onduleur, dans lequel un connecteur (110) du premier système électrique (100) traverse le C magnétique (31, 32, 33) à travers ladite ouverture principale (O) pour venir en contact avec la première portion (51, 52, 53) du conducteur électrique (41, 42, 43) de sorte que le C magnétique (31, 32, 33) est configuré pour générer un champ magnétique fonction du courant circulant dans ledit connecteur (110) du premier système électrique (100).

10. Ensemble selon la revendication précédente, comprenant en outre un deuxième système électrique (200), notamment une machine électrique, dans lequel un connecteur (210) du deuxième système électrique (200), notamment un connecteur de phase de la machine électrique, est connecté à la deuxième partie (61,62,63) du conducteur électrique (41, 42, 43) du capteur (1), et dans lequel la dimension de la première portion (51, 52, 53) du conducteur électrique (41, 42, 43) suivant une direction perpendiculaire au plan principal du C magnétique (31, 32, 33) est inférieure à la dimension de la deuxième portion (61, 62, 63) du conducteur électrique (41, 42, 43) suivant la direction perpendiculaire au plan principal du C magnétique (31, 32, 33).

## Patentansprüche

1. Messfühler (1), der zur Messung eines Ausgangsstroms eines ersten elektrischen Systems (100), das mit einem zweiten elektrischen System (200) verbunden ist, bestimmt ist, wobei der Messfühler (1) mindestens ein magnetisches C (31, 32, 33) beinhaltet, das sich in einer Hauptebene, in der es eine C-Form aufweist, erstreckt, wobei das magnetische C (31, 32, 33) eine Hauptöffnung (O) aufweist, die in der Hauptebene durch die C-Form begrenzt wird, wobei der Messfühler (1) mindestens einen elektrischen Leiter (41, 42, 43) beinhaltet, der mindestens einen ersten Abschnitt (51, 52, 53), der dazu konfiguriert ist, einen elektrischen Verbinder (110) des ersten elektrischen Systems (100) aufzunehmen, und mindestens einen zweiten Abschnitt (61, 62, 63), der dazu konfiguriert ist, einen elektrischen Verbinder (210) des zweiten elektrischen Systems (200) aufzunehmen, umfasst, um eine elektrische Verbindung zwischen dem ersten und dem zweiten elektrischen System (100, 200) zu gewährleisten, wobei sich der erste Abschnitt (51, 52, 53) gegenüber der Hauptöffnung (O) des magnetischen Cs (31, 32, 33) befindet, **dadurch gekennzeichnet, dass** der zweite Abschnitt (61, 62, 63) gemäß der Hauptebene mit Bezug auf das magnetische C (31, 32, 33) versetzt ist.

2. Messfühler (1) nach Anspruch 1, wobei die Hauptebene des mindestens einen magnetischen Cs (31, 32, 33) zu einer Ebene orthogonal ist, gemäß der sich der mindestens eine zweite Abschnitt (61, 62, 63) des elektrischen Leiters (41, 42, 43) erstreckt.

3. Messfühler (1) nach einem der vorhergehenden Ansprüche, wobei der elektrische Leiter (41, 42, 43) einen dritten Abschnitt (71, 72, 73) beinhaltet, der den ersten Abschnitt (51, 52, 53) und den zweiten Abschnitt (61, 62, 63) verbindet, wobei sich der dritte Abschnitt (71, 72, 73) so erstreckt, dass sich der zweite Abschnitt (61, 62, 63) gemäß einer zu der Hauptebene des magnetischen Cs (31, 32, 33) parallelen Richtung von dem ersten Abschnitt (51, 52, 53) und von dem magnetischen C (31, 32, 33) beabstandet befindet.

4. Messfühler (1) nach dem vorhergehenden Anspruch, wobei sich der zweite Abschnitt (61, 62, 63) und der dritte Abschnitt (71, 72, 73) in Richtungen erstrecken, die einen Winkel zwischen ungefähr 45° und 135°, vorzugsweise im Wesentlichen gleich 90°, bilden.

5. Messfühler (1) nach Anspruch 3 oder 4, wobei der elektrische Leiter (41, 42, 43) eine Zunge umfasst, die einen Absatz (80) beinhaltet, der sich von einem ersten Endteil der Zunge bis zu einem zweiten Endteil der Zunge, der zu dem ersten Endteil entgegengesetzt ist, erstreckt, wobei der zweite Abschnitt (61, 62, 63) des elektrischen Leiters (41, 42, 43) in dem ersten Endteil enthalten ist, der Absatz (80) den dritten Abschnitt (71, 72, 73) des elektrischen Leiters (41, 42, 43) definiert und das magnetische C (31, 32, 33) mindestens teilweise in dem Absatz (80) aufgenommen ist.

6. Messfühler (1) nach einem der vorhergehenden Ansprüche, der drei erste Abschnitte (51, 52, 53), die dazu bestimmt sind, jeweilige elektrische Verbinder (110) des ersten elektrischen Systems (100) aufzunehmen, und drei zweite Abschnitte (51, 52, 53), die dazu bestimmt sind, jeweilige elektrische Verbinder (210) des zweiten elektrischen Systems (200) aufzunehmen, beinhaltet, wobei der Messfühler (1) drei magnetische Cs (31, 32, 33) beinhaltet, um das Messen des Magnetfelds zu gestatten, das durch einen jeweiligen Strom, der zwischen einem Verbinder (110) des ersten elektrischen Systems (100) und einem jeweiligen Verbinder (210) des zweiten elektrischen Systems (200) fließt, induziert wird.

7. Messfühler (1) nach einem der vorhergehenden Ansprüche, der mindestens ein Element (21), das gegenüber dem Magnetfeld in dem Luftspalt (35) des mindestens einen magnetischen Cs (31, 32, 33) empfindlich ist, sowie eine Schaltung zur Bestimmung eines Stroms in Abhängigkeit von dem Wert des gemessenen Magnetfelds beinhaltet.

8. Anordnung, die eine elektronische Steuerkarte (2) und einen Messfühler (1) nach dem vorhergehenden Anspruch beinhaltet, wobei die elektronische Steuerkarte (2) das Element (21), das gegenüber dem Magnetfeld in dem Luftspalt (35) des mindestens einen magnetischen Cs (31, 32, 33) empfindlich ist, und die Schaltung zur Bestimmung eines Stroms in Abhängigkeit von dem Wert des gemessenen Magnetfelds beinhaltet.

9. Anordnung, die einen Messfühler (1) nach einem der Ansprüche 1 bis 7 und ein erstes elektrisches System (100), insbesondere einen Wechselrichter, beinhaltet, wobei ein Verbinder (110) des ersten elektrischen Systems (100) das magnetische C (31, 32, 33) durch die Hauptöffnung (O) hindurch durchquert, um mit dem ersten Abschnitt (51, 52, 53) des elektrischen Leiters (41, 42, 43) in Kontakt zu kommen, sodass das magnetische C (31, 32, 33) dazu konfiguriert ist, in Abhängigkeit von dem Strom, der in dem Verbinder (110) des ersten elektrischen Systems (100) fließt, ein Magnetfeld zu erzeugen.

10. Anordnung nach dem vorhergehenden Anspruch, die ferner ein zweites elektrisches System (200), insbesondere eine elektrische Maschine, beinhaltet, wobei ein Verbinder (210) des zweiten elektrischen Systems (200), insbesondere ein Phasenverbinder der elektrischen Maschine, mit dem zweiten Teil (61, 62, 63) des elektrischen Leiters (41, 42, 43) des Messfühlers (1) verbunden ist und wobei die Abmessung des ersten Abschnitts (51, 52, 53) des elektrischen Leiters (41, 42, 43) gemäß einer zu der Hauptebene des magnetischen Cs (31, 32, 33) senkrechten Richtung kleiner ist als die Abmessung des zweiten Abschnitts (61, 62, 63) des elektrischen Leiters (41, 42, 43) gemäß der zu der Hauptebene des magnetischen Cs (31, 32, 33) senkrechten Richtung.

## Claims

1. Sensor (1) intended to measure an output current of a first electrical system (100) connected to a second electrical system (200), said sensor (1) comprising at least one magnetic C (31, 32, 33) extending in a main plane in which it has a C shape, said magnetic C (31, 32, 33) having a main opening (O) that is delimited in the main plane by said C shape, said sensor (1) comprising at least one electrical conductor (41, 42, 43) that includes at least one first section (51, 52, 53) configured to receive an electrical connector (110) of the first electrical system (100) and at least one second section (61, 62, 63) configured to receive an electrical connector (210) of the second electrical system (200) so as to ensure an electrical link between the first and the second electrical system (100, 200), said first section (51, 52, 53) facing the main opening (O) of the magnetic C (31, 32, 33), **characterized in that** the second section (61, 62, 63) is situated away from the magnetic C (31, 32, 33) in the main plane.

2. Sensor (1) according to Claim 1, wherein the main plane of said at least one magnetic C (31, 32, 33) is orthogonal to a plane along which said at least one second section (61, 62, 63) of the electrical conductor (41, 42, 43) extends.

3. Sensor (1) according to either of the preceding claims, wherein the electrical conductor (41, 42, 43) comprises a third section (71, 72, 73) connecting the first section (51, 52, 53) and the second section (61, 62, 63), the third section (71, 72, 73) extending such that the second section (61, 62, 63) is at a distance from the first section (51, 52, 53) and from the magnetic C (31, 32, 33) along a direction parallel to said main plane of the magnetic C (31, 32, 33).

4. Sensor (1) according to the preceding claim, wherein said second section (61, 62, 63) and said third section (71, 72, 73) extend in directions that form an angle comprised between about 45° and 135°, preferably substantially equal to 90°.

5. Sensor (1) according to Claim 3 or 4, wherein the electrical conductor (41, 42, 43) includes a strip comprising a recess (80) extending from a first end portion of the strip to a second end portion of the strip which is opposite the first end portion, said second section (61, 62, 63) of the electrical conductor (41, 42, 43) being comprised in the first end portion, said recess (80) defining said third section (71, 72, 73) of the electrical conductor (41, 42, 43), and the magnetic C (31, 32, 33) being at least partially accommodated in said recess (80).

6. Sensor (1) according to one of the preceding claims, comprising three first sections (51, 52, 53) intended to receive respective electrical connectors (110) of the first electrical system (100) and three second sections (51, 52, 53) intended to receive respective electrical connectors (210) of the second electrical system (200), said sensor (1) comprising three magnetic Cs (31, 32, 33) for measuring the magnetic field induced by a respective current flowing between a respective connector (110) of the first electrical system (100) and a respective connector (210) of the second electrical system (200).

7. Sensor (1) according to one of the preceding claims, comprising at least one element (21) that is sensitive to the magnetic field in the air gap (35) of said at least one magnetic C (31, 32, 33), and a circuit for determining a current as a function of the value of the magnetic field measured.

8. Assembly comprising an electronic control board (2) and a sensor (1) according to the preceding claim, said electronic control board (2) comprising said element (21) that is sensitive to the magnetic field in the air gap (35) of said at least one magnetic C (31, 32, 33) and said circuit for determining a current as a function of the value of the magnetic field measured.

9. Assembly comprising a sensor (1) according to one of Claims 1 to 7 and a first electrical system (100), in particular an inverter, wherein a connector (110) of the first electrical system (100) passes through the magnetic C (31, 32, 33) through said main opening (O) so as to come into contact with the first section (51, 52, 53) of the electrical conductor (41, 42, 43) such that the magnetic C (31, 32, 33) is configured to generate a magnetic field as a function of the current flowing through said connector (110) of the first electrical system (100).

10. Assembly according to the preceding claim, further comprising a second electrical system (200), in particular an electrical machine, wherein a connector (210) of the second electrical system (200), in particular a phase connector of the electrical machine, is connected to the second part (61, 62, 63) of the electrical conductor (41, 42, 43) of the sensor (1), and wherein the dimension of the first section (51, 52, 53) of the electrical conductor (41, 42, 43) along a direction perpendicular to the main plane of the magnetic C (31, 32, 33) is less than the dimension of the second section (61, 62, 63) of the electrical conductor (41, 42, 43) along the direction perpendicular to the main plane of the magnetic C (31, 32, 33).
